# EUROPEAN PATENT SPECIFICATION

(11) **EP 1 084 009 B1**
(45) Date of publication and mention of the grant of the patent: **17.03.2004**
(21) Application number: 00919794.8
(22) Date of filing: 29.03.2000
(51) Int. Cl.: B24B 37/04, B24B 53/007, B24B 53/013, B24D 13/14, B24D 13/18, B24D 7/10

(54) **CMP PAD CONDITIONER ARRANGEMENT AND METHOD THEREFOR**
HERRICHTUNGSANORDNUNG EINER CHEMISCH-MECHANISCHEN POLIERSCHEIBE UND DAZUGEHÖRIGES VERFAHREN
DISPOSITIF ET PROCEDE DE CONDITIONNEMENT DE TAMPONS DE POLISSAGE CHIMIQUE ET MECANIQUE

(30) Priority: 01.04.1999 US 283049
(43) Date of publication of application: 21.03.2001
(73) Proprietor: Koninklijke Philips Electronics N.V., 5621 BA Eindhoven (NL)
(72) Inventor: LIU, Albert, H., San Antonio, TX (US); VINES, Landon, San Antonio, TX 78240 (US)
(74) Representative: Duijvestijn, Adrianus Johannes
(86) International application number: PCT/US2000/008302
(87) International publication number: WO 2000/059681

(56) References cited:
- EP-A- 0 345 239
- EP-A- 0 887 153
- FR-A- 2 580 974
- FR-A- 2 633 860
- FR-A- 2 704 473
- JP-A- 11 010 524
- US-A- 3 041 799
- US-A- 5 775 980
- PATENT ABSTRACTS OF JAPAN vol. 1999, no. 11, 30 September 1999 (1999-09-30) -& JP 11 165266 A (TOSHIBA CORP), 22 June 1999 (1999-06-22)

## Description

The present device relates generally to semiconductor devices and their fabrication and, more particularly, to semiconductor devices and tools for their manufacture involving chemical-mechanical polishing (CMP), as for example known from document JP-A-110 105 24.

### Background of the Invention

The electronics industry continues to rely upon advances in semiconductor manufacturing technology to realize higher-functioning devices while improving reliability and cost. For many applications, the manufacture of such devices is complex, and maintaining cost-effective manufacturing processes while concurrently maintaining or improving product quality is difficult to accomplish. As the requirements for device performance and cost become more demanding, realizing a successful manufacturing process becomes more difficult.

A byproduct of the increased complexity of semiconductor devices includes uneven device surfaces, which become more prominent as additional levels are added to multilevel-interconnection schemes and circuit features are scaled to submicron dimensions. Typically, each level within the device is patterned, resulting in a surface with varied "step-heights" where metal forming the pattern remains on the surface.

Planarization is a term describing the surface geometry of a semiconductor device. Complete planarization occurs when the surface of the dielectric is flat, as in a plane. No planarization occurs when the surface of the dielectric directly models the "step-height" surface of the metal pattern in the layer underneath. The degree of planarization refers to the degree to which the varied surface geometry can be "planarized," or smoothed out into a planar surface. Varied surface geometry is often undesirable. Therefor, as additional layers are formed within devices, the required degree of planarization increases.

A commonly used new planarization process in semiconductor device manufacturing is chemical-mechanical polishing, or CMP. CMP is useful in the planarization of silicon wafers and of VLSI circuits between different manufacturing processes. CMP is a popular planarization method, due in part to its usefulness in the global planarization of semiconductor devices. Traditional planarization processes are restricted to effecting local planarity or topographical variation on a small scale, whereas CMP is often useful on a global scale greater than ten microns.

In one application, a CMP process involves securing a semiconductor wafer to a wafer holder with the wafer located face-down on a polish pad. Both the polish pad and the wafer rotate. A slurry, typically a colloidal silica that is a suspension of SiO₂ particles, is applied to the process. The particle size typically varies from 100 angstroms to 3 microns. The slurry is generally applied using a wand feeding to the wafer holder and pad. The rate of removal of material from the wafer is a combination of chemical and mechanical rates. The mechanical removal rate is roughly proportional to the pressure and the relative velocity of the wafer. The chemical removal rate is a function of the size of the slurry particles and the solution pH, wherein the maximum removal rate is generally obtained using a slurry having a pH of about 11.5.

In addition to the use of slurry in the CMP process, a conditioner is also typically used for conditioning the polish pad. The conditioner aids in the CMP polishing process and contributes to the longevity of the pad. Another need in the CMP process is for adequately and efficiently cleaning the pad and the wafer itself. In clean room environments, it is important to maintain a CMP process that produces as few contaminants as possible. Since the slurry particle size ranges in the sub-3 micron range, clean-up is difficult and thus of high importance. In addition, it is helpful to prevent the byproduct resulting from the polishing of each wafer from accumulating on the pad and reaching additional wafers.

The traditional method for conditioning the pad and dispensing slurry is to use two separate mechanical components: a slurry dispense wand and a pad conditioner assembly. There are disadvantages in using two separate components. For instance, the slurry cannot be spread uniformly across the pad and may accumulate in the pad conditioning head. The non-uniform distribution of slurry distribution hinders the polishing process. In addition, the reaction byproduct cannot be thoroughly removed from the pad. When more than one wafer is processed at once, inadequate cleaning of the pad results in the reaction byproduct and other materials from one wafer coming into contact with other wafers. These disadvantages may result in, for example, long arc style scratches, shallow micro-scratches, inter-die thickness variation, and residual slurry particles. These disadvantages ultimately result in a significant yield lost and in reliability problems due in part to possible metal stringers in the shallow scratch area and surrounding residual slurry particles.

### Summary of the Invention

The present invention is directed to a method and apparatus for improving the CMP process, the improvements including but not limited to enhanced pad cleaning and conditioning, better slurry dispense, improved wafer quality, and faster production. The present invention is exemplified in a number of implementations and applications, some of which are summarized below.

According to an embodiment, the present invention comprises a CMP pad conditioner arrangement comprising the features of claim 1.

According to another embodiment, the present invention is directed to a method of conditioning a CMP pad comprising the features of claim 7.

According to still another embodiment, the present invention is directed to a method of manufacturing a semiconductor device comprising the features of claim 8.

The above summary of the present invention is not intended to describe each illustrated embodiment or every implementation of the present invention. The figures and detailed description which follow more particularly exemplify these embodiments.

### Brief Description of the Drawings

The invention may be more completely understood in consideration of the following detailed description in connection with the accompanying drawings, in which:
FIG. 1 shows top and side views of a first CMP pad conditioner arrangement, according to an embodiment of the present invention;
FIG. 2 shows top and side views of a second CMP pad conditioner arrangement, according to another embodiment of the present invention; and
FIG. 3 shows top and side views of a third CMP pad conditioner arrangement, according to another embodiment of the present invention.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the scope of the invention as defined by the appended claims.

### Detailed Description

According to an embodiment, the present invention is directed to an arrangement for use in a CMP process. The arrangement includes capabilities for receiving, dispersing, and dispensing treatment elements, as well as for conditioning the CMP pad. In addition, the arrangement may also include the capability of rotation. The conditioning of the pad may include, for example, removing deposits, roughing the pad, or other preparations for use in the CMP process. The arrangement includes an inlet port for receiving treatment elements. A distribution surface is coupled to the inlet port and is configured and arranged to disperse the treatment elements. A multitude of outlet ports are coupled to the distribution surface and are configured and arranged to dispense the treatment elements onto the CMP pad.

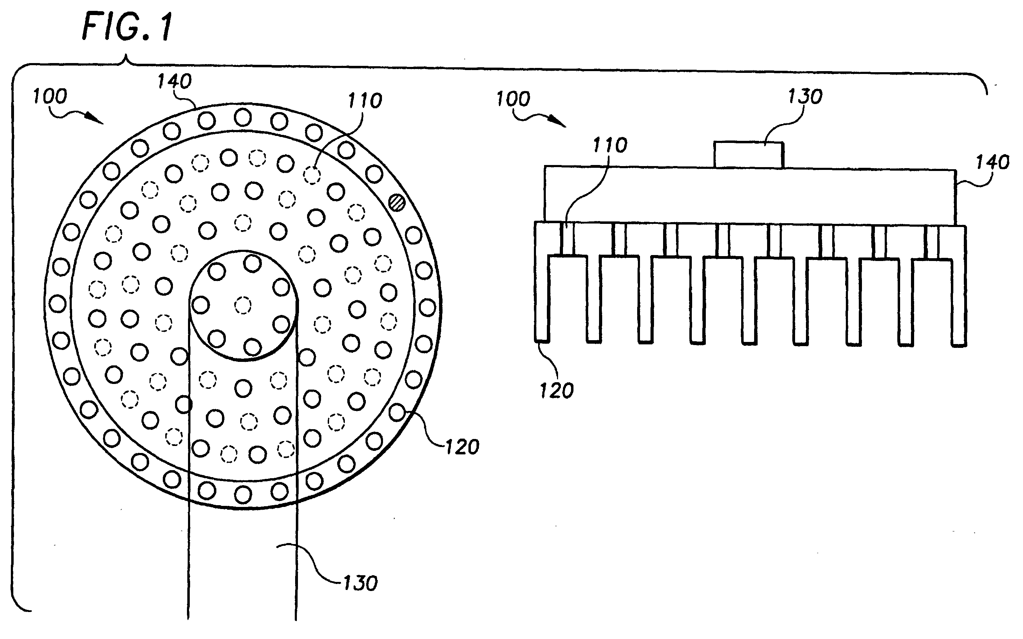

FIG. 1 shows top and side views of a CMP pad conditioner arrangement 100 for use in a CMP process, according to another embodiment of the present invention. Supply 130 is configured and arranged to supply treatment elements to the pad conditioner head 140. Pad conditioner head 140 includes holes 110 for dispensing treatment elements to the surface to be conditioned. Brushes 120 are coupled to the pad conditioner head 140. The brushes may, for instance, comprise chemically resistant material, such as plastic or Teflon. The use of chemically resistant brushes is particularly advantageous in applications where the treatment elements include chemicals that are reactive with non-chemically resistant brush material.

According to another embodiment, a method for conditioning a CMP pad is provided. Referring again to FIG. 1, supply 130 is coupled to pad conditioner head 140. Treatment elements are delivered to the pad conditioner head 140 by way of supply 130. The treatment elements may include, for example, chemicals ranging in pH from highly basic to highly acidic, or solvents such as de-ionized (DI) water. The treatment elements are dispersed in the head 140, and dispensed through holes 110. Brushes 120 are coupled to pad conditioner head 140, and are caused to contact a CMP pad. The treatment elements are dispersed onto the CMP pad, and the CMP pad is conditioned. Conditioning the CMP pad may, for instance, also include rotating the pad conditioner head 140, in a manner such as rotating about its center.

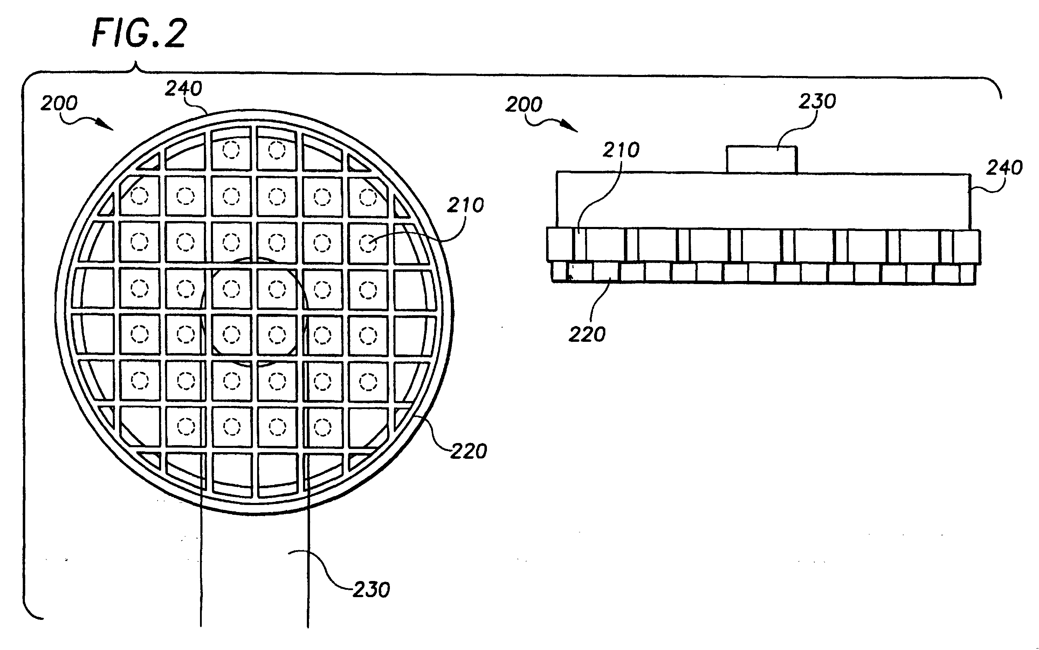

FIG. 2 shows top and side views of a CMP pad conditioner arrangement 200 for use in a CMP process, according to another embodiment of the present invention. Supply 230 is configured and arranged to supply treatment elements to the pad conditioner head 240. Pad conditioner head 240 includes holes 210, for dispensing treatment elements to the surface to be conditioned. Grid arrangement 220 is coupled to the pad conditioner head 240. For instance, grid arrangement 220 may include material such as diamond or CVD diamond coated with Ni.

According to another embodiment, a method for conditioning a CMP pad is provided. Referring again to FIG. 2, supply 230 is coupled to pad conditioner head 240. Treatment elements are delivered to the pad conditioner head 240 by way of supply 230. The treatment elements are dispersed in the head 240, and dispensed through holes 210. Grid arrangement 220 is coupled to pad conditioner head 240, and is caused to contact a CMP pad. The treatment elements are dispersed onto the CMP pad, and the CMP pad is conditioned. Conditioning the CMP pad may, for instance, also include rotating the pad conditioner head 240, in a manner such as rotating about its center using a motor/axle arrangement (not shown) coupled to the housing for the supply 230 (or 130).

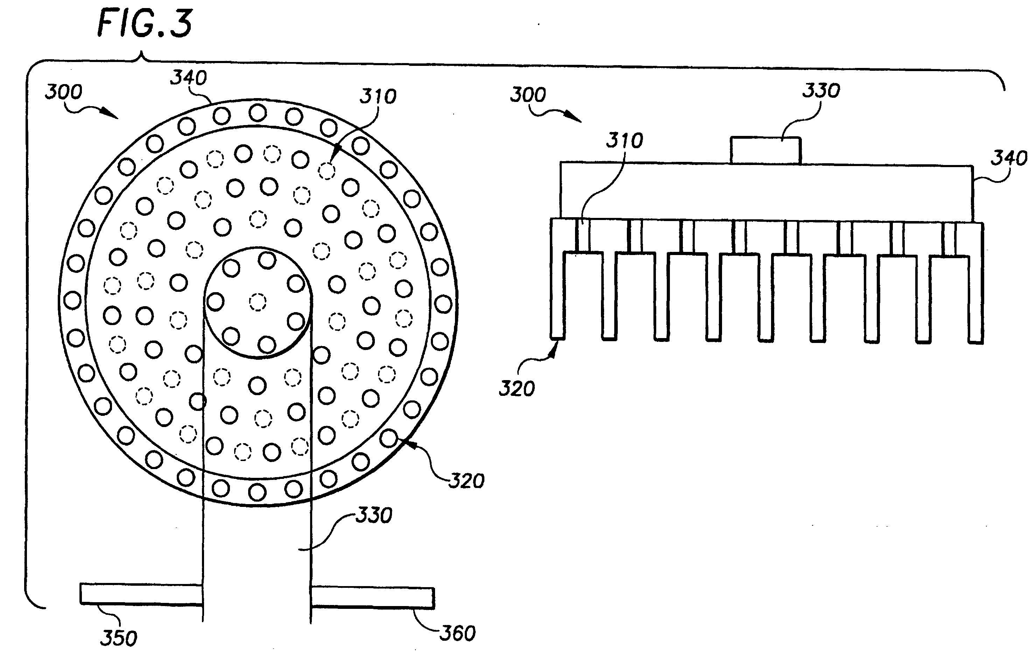

FIG. 3 shows top and side views of a CMP pad conditioner arrangement 300 for cleaning a pad in a CMP process, according to another embodiment of the present invention. Treatment element supplies 350 and 360 are configured and arranged to supply elements to supply 330. Supply 330 is configured and arranged to supply treatment elements to the pad conditioner head 340. Pad conditioner head 340 includes holes 310, for dispensing treatment elements to the surface to be conditioned. Brushes 320 are coupled to the pad conditioner head 340.

According to another embodiment, a method for conditioning a CMP pad is provided. Referring again to FIG. 3, treatment element supplies 350 and 360 are coupled to supply 330. Supply 330 is coupled to pad conditioner head 340. Treatment elements are delivered to pad conditioner head 340 by way of supply 330. The treatment elements are dispersed in the head 340, and dispensed through holes 310. Brush arrangement 320 is coupled to pad conditioner head 340, and is caused to contact a CMP pad. The treatment elements are dispersed onto the CMP pad, and the CMP pad is conditioned. Conditioning the CMP pad may, for instance, also include rotating the pad conditioner head 340, in a manner such as rotating about its center.

Treatment element supplies 350 and 360 may be used to supply several different elements. For instance, one supply may be used to supply chemicals, and the other used to supply DI water. In an embodiment, pad conditioner arrangement 300 is used in connection with a metal polish process, in which the chemical supply includes a low pH chemical. In another example embodiment, pad conditioner arrangement 300 is used in an oxide polish process, in which the chemical supply includes a high pH chemical, such as, for example, a chemical having a pH of about 11.5.

Skilled artisans will recognize that the above-discussed embodiments may be implemented by modifying commercially-available equipment. Examples of such equipment include MIRRA and 6DS SP, respectively manufactured by Applied Material and Strausbough.

While the present invention has been described with reference to several particular embodiments, those skilled in the art will recognize that many changes may be made thereto. For example, many features of the above embodiments are combinable in a single conditioner arrangement and/or conditioning process. Such changes do not depart from the scope of the present invention, which is set forth in the following claims.

## Claims

1. CMP pad conditioner arrangement (100,200,300), comprising
- at least one inlet port (130,230,330) for receiving treatment elements;
- a distribution surface (140,240,340) coupled to the inlet port (130,230,330) and configured and arranged to disperse the treatment elements; and
- a multitude of outlet ports (110,210,310) coupled to the distribution surface (140,240,340) and configured and arranged to dispense the treatment elements onto a CMP pad,
**characterized in that** the arrangement further comprises:
- a brush arrangement (120, 320) or a grid arrangement (220), which is arranged to contact the CMP pad, and
- a rotation device configured to rotate the distribution surface (140,240,340).

2. CMP pad conditioner arrangement (100,200,300) according to Claim 1, wherein the distribution surface is present in a pad conditioner head (140,240,340) to which the brush or the grid arrangement (120, 220,320) is coupled.

3. CMP pad conditioner arrangement according to Claim 1 or 2, **characterized in that**
- the pad conditioner arrangement (100,200,300) has an outlet side, at which side the outlet ports (110, 210, 310) are present, and
- the brush or grid arrangement (120,220,320) is present at the outlet side, such that the outlet ports (110, 210,3 10) are distributed along that side in between of the brushes or grid parts (120,220,320).

4. CMP pad conditioner arrangement (200) according to Claim 3, wherein the brush or grid arrangement is a grid arrangement (220) comprises holes to allow the treatment elements to be dispensed from the outlet ports (210) onto the CMP pad.

5. CMP pad conditioner arrangement (100,300) according to Claim 3, wherein the brush or grid arrangement is a brush arrangement (120,320).

6. CMP polishing machine comprising the CMP pad conditioner arrangement (100,200,300) according to any of the Claims 1-5.

7. A method of conditioning a CMP pad, wherein use is made of the CMP pad conditioner arrangement (100,200,300) according to any of the Claims 1-5 for providing the treatment elements to the CMP pad.

8. A method of manufacturing a semiconductor device, in which manufacture a semiconductor wafer is planarized with chemical-mechanical polishing (CMP), which polishing comprises the steps of:
- securing the semiconductor wafer to a wafer holder having a polishing pad, with the wafer located face-down on the polish pad;
- applying a slurry to the polish pad, while both the wafer and the polish pad rotate, therewith polishing the wafer and removing material from the wafer, and in addition thereto,
- conditioning the polish pad, therewith cleaning the pad and in order to remove from the pad reaction byproduct and other material removed from the wafer,
- in which CMP process use is made of the CMP pad conditioner arrangement (100,200,300) according to any of the Claims 1-5.

## Patentansprüche

1. CMP-Pad-Konditionierungsanordnung (100, 200, 300), mit
- mindestens einen Einlassanschluss (130, 230, 330) zum Aufnehmen von Bearbeitungsgrundstoffen;
- einer Verteilungsoberfläche (140, 240, 340), die an den Einlassanschluss (130, 230, 330) gekoppelt ist und zum Verteilen der Bearbeitungsgrundstoffe konfiguriert und angeordnet ist; und
- einer Vielzahl von an die Verteilungsoberfläche (140, 240, 340) gekoppelten Auslassöffnungen (110, 210, 310), die konfiguriert und angeordnet sind, um die Bearbeitungsgrundstoffe auf ein CMP-Pad auszugeben,
**dadurch gekennzeichnet, dass** die Anordnung weiterhin umfasst:
- eine Bürsten-Anordnung (120, 320) oder eine Gitter-Anordnung (220), die darauf eingerichtet ist, das CMP-Pad zu kontaktieren, und
- eine Rotationsvorrichtung, die konfiguriert ist, die Verteilungsoberfläche (140, 240, 340) in Rotation zu versetzen.

2. CMP-Pad-Konditionierungsanordnung (100, 200, 300) nach Anspruch 1, in der sich die Verteilungsoberfläche in einem Pad-Konditionierungs-Kopf (140, 240, 340) befindet, an den die Bürsten- oder Gitter-Anordnung (120, 220, 230) gekoppelt ist.

3. CMP-Pad-Konditionierungsanordnung nach Anspruch 1 oder 2, **dadurch gekennzeichnet, dass**
- die Pad-Konditionierungsanordnung (100, 200, 300) eine Auslassseite hat, an der sich die Auslassöffnungen (110, 210, 310) befinden, und
- sich die Bürsten- oder Gitter-Anordnung (120, 220, 320) an der Auslassseite befindet, derart, dass die Auslassöffnungen (110, 210, 310) auf dieser Seite zwischen den Bürsten oder Gitterteilen (120, 220, 320) verteilt sind.

4. CMP-Pad-Konditionierungsanordnung (200) nach Anspruch 3, in der die Bürsten- oder Gitter-Anordnung eine Gitter-Anordnung (220) ist und Löcher enthält, die es ermöglichen, die Bearbeitungsgrundstoffe von den Auslassöffnungen (210) aus auf das CMP-Pad auszugeben.

5. CMP-Pad-Konditionierungsanordnung (100, 300) nach Anspruch 3, in der die Bürsten- oder Gitter-Anordnung eine Bürsten-Anordnung (120, 320) ist.

6. CMP-Polier-Maschine, die die CMP-Pad-Konditionierungsanordnungen (100, 200, 300) nach einem der Ansprüche 1-5 umfasst.

7. Verfahren zur Konditionierung eines CMP-Pads, bei dem die CMP-Pad-Konditionierungsanordnung (100, 200, 300) nach einem der Ansprüche 1-5 verwendet wird, um die Bearbeitungsgrundstoffe auf das CMP-Pad zu bringen.

8. Verfahren zur Herstellung eines Halbleiterbauelements, bei dessen Herstellung eine Halbleiterscheibe mit chemisch-mechanischer Planarisierung (CMP) planarisiert wird, wobei das Polieren folgende Schritte umfasst:
- Sicherung der Halbleiterscheibe auf einem Scheibenträger mit einem Polierpad, mit der aktiven Seite der Scheibe nach unten auf dem Polierpad;
- Aufbringung von Slurry auf das Polierpad, wobei die Scheibe und auch das Polierpad rotieren und damit die Scheibe polieren und Material von der Scheibe entfernen, und zusätzlich dazu
- das Polierpad konditionieren und damit das Pad reinigen und um Reaktionsnebenprodukte und anderes Material, das von der Scheibe entfernt wurde, zu entfernen,
- wobei im CMP-Prozess die CMP-Pad-Konditionierungsanordnung (100, 200,300) nach einem der Ansprüche 1-5 verwendet werden.

## Revendications

1. Dispositif de conditionnement de plateau CMP (100,200,300) comprenant :
- au moins une lumière d'entrée (130,230,330) destinée à recevoir des éléments de traitement;
- une surface de distribution (140,240,340) raccordée à la lumière d'entrée (130,230,330) et configurée et arrangée pour disperser les éléments de traitement, et
- une pluralité de lumières de sortie (110,210,310) raccordées à la surface de distribution (140,240,340) et configurées et arrangées pour distribuer les éléments de traitement sur un plateau CMP,
**caractérisé en ce que** le dispositif comporte en outre :
- un ensemble de brosses (120,320) ou un grillage (220) arrangé pour établir un contact avec le plateau CMP, et
- un dispositif de rotation configuré pour faire tourner la surface de distribution (140,240,340).

2. Dispositif de conditionnement de plateau CMP (100,200,300) suivant la revendication 1, dans lequel la surface de distribution est présente dans une tête de conditionnement de plateau (140,240,340) à laquelle l'ensemble de brosses ou le grillage (120,220,320) est relié.

3. Dispositif de conditionnement de plateau CMP suivant la revendication 1 ou 2, **caractérisé en ce que**
- le dispositif de conditionnement de plateau CMP (100,200,300) présente un côté de sortie au niveau duquel les lumières de sortie (110,210,320) sont présentes, et
- l'ensemble de brosses ou le grillage (120,220,320) est présent du côté de sortie, de sorte que les lumières de sortie (110,210,310) sont distribuées le long de ce côté entre les brosses ou les parties de grillage (120,220,320).

4. Dispositif de conditionnement de plateau CMP (200) suivant la revendication 3, dans lequel l'ensemble de brosses ou le grillage est un grillage (220) qui comprend des trous pour permettre aux éléments de traitement d'être distribués par les lumières de sortie (210) sur le plateau CMP.

5. Dispositif de conditionnement de plateau CMP (100,300) suivant la revendication 3, dans lequel l'ensemble de brosses ou le grillage est un ensemble de brosses (120,320).

6. Machine de polissage CMP comprenant le dispositif de conditionnement de plateau CMP (100,200,300) suivant l'une quelconque des revendications 1-5.

7. Procédé de conditionnement d'un plateau CMP, dans lequel on utilise le dispositif de conditionnement de plateau CMP (100,200,300) suivant l'une quelconque des revendications 1-5 pour fournir les éléments de traitement au plateau CMP.

8. Procédé de fabrication d'un dispositif à semi-conducteur, dans lequel la fabrication d'une plaquette à semi-conducteurs est planarisée au moyen d'un polissage chimique et mécanique(CMP), lequel polissage comprend les étapes suivantes :
- fixer la plaquette à semi-conducteurs à un porte-plaquette comportant un plateau de polissage, la plaquette étant placée face vers le bas sur le plateau de polissage;
- appliquer un produit à polir sur le plateau de polissage, pendant que la plaquette et le plateau de polissage tournent, polissant de ce fait la plaquette et éliminant du matériau de la plaquette, et en outre,
- conditionner le plateau de polissage, nettoyer le plateau pour en éliminer le sous-produit réactif et tout autre matériau éliminé de la plaquette,
- dans lequel processus CMP le dispositif de conditionnement r de plateau CMP (100,200,300) est utilisé suivant l'une quelconque des revendications 1-5.
